(19) Europäisches Patentamt
European Patent Office
Office européen des brevets

(11) **EP 4 213 597 A1**

(12) **EUROPEAN PATENT APPLICATION**
published in accordance with Art. 153(4) EPC

(43) Date of publication:
**19.07.2023 Bulletin 2023/29**

(21) Application number: **21866796.2**

(22) Date of filing: **08.09.2021**

(51) International Patent Classification (IPC):
*H05H 1/24* (2006.01)   *C04B 41/87* (2006.01)
*H01L 21/3065* (2006.01)   *C23C 18/12* (2006.01)

(52) Cooperative Patent Classification (CPC):
**C04B 41/87; C23C 18/12; H01L 21/3065; H05H 1/24**

(86) International application number:
**PCT/JP2021/033028**

(87) International publication number:
**WO 2022/054837 (17.03.2022 Gazette 2022/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.09.2020   JP 2020150914**
**02.09.2021   JP 2021142939**

(71) Applicant: **Mitsubishi Materials Corporation
Tokyo 100-8117 (JP)**

(72) Inventors:
• **TSUJIUCHI, Naoto**
  **Sanda-shi, Hyogo 669-1339 (JP)**
• **TATSUMI, Koji**
  **Sanda-shi, Hyogo 669-1339 (JP)**
• **SHIONO, Ichiro**
  **Sanda-shi, Hyogo 669-1339 (JP)**

(74) Representative: **Gille Hrabal
Partnerschaftsgesellschaft mbB
Patentanwälte
Brucknerstraße 20
40593 Düsseldorf (DE)**

(54) **PLASMA-RESISTANT COATING FILM, SOL GEL LIQUID FOR FORMING SAID FILM, METHOD FOR FORMING PLASMA-RESISTANT COATING FILM, AND SUBSTRATE WITH PLASMA-RESISTANT COATING FILM**

(57)   The plasma-resistant coating film according to the present invention is formed on a substrate, including crystalline $Y_2O_3$ particles having an average particle diameter of 0.5 $\mu$m to 5.0 $\mu$m in a $SiO_2$ film, in which a film density of the plasma-resistant coating film is 90% or more, the film density being obtained by performing image analysis of a cross section of the film with an electron scanning microscope and by using the following expression (1), a size of pores in the film is 5 $\mu$m or less in terms of diameter, and a peeling rate of the film from the substrate measured by performing a cross-cut test is 5% or less.

$$\text{Film density } (\%) = [(S_1 - S_2)/S_1] \times 100 \quad (1)$$

However, in the expression (1), $S_1$ is an area of the film and $S_2$ is an area of a pore portion in the film.

FIG. 1

**Description**

TECHNICAL FIELD

The present invention relates to a plasma-resistant coating film for a plasma treatment apparatus, a sol gel liquid for forming this film, a method for forming a plasma-resistant coating film, and a substrate with a plasma-resistant coating film.

Priority is claimed on Japanese Patent Application No. 2020-150914, filed September 9, 2020, and Japanese Patent Application No. 2021-142939, filed September 2, 2021, the contents of which are incorporated herein by reference.

BACKGROUND ART

In the related art, as a type of a plasma treatment apparatus part, a plasma treatment apparatus part including a substrate, an underlayer covering a surface of the substrate, and an yttrium oxide film covering a surface of the underlayer; and a method for manufacturing a plasma treatment apparatus part, the method including a step of forming the underlayer by a thermal spraying method; a step of supplying raw slurry containing yttrium oxide raw powder to combustion flame sprayed from a combustion chamber; and a step of spraying the yttrium oxide raw powder in the combustion flame on the surface of the substrate to cover the surface of the substrate at a spraying speed of 400 to 1000 m/sec are disclosed (for example, see Patent Document 1 (Claim 1, Claim 9, and paragraph [0021])). The above-described underlayer consists of a metal oxide film having a thermal conductivity of 35 W/m·K or less; the yttrium oxide film includes at least either particulate portions made of yttrium oxide or non-particulate portions made of yttrium oxide, the particulate portions being portions where a grain boundary demarcating an outer portion of the grain boundary is observed under a microscope, and the non-particulate portions being portions where the grain boundary is not observed under a microscope; the yttrium oxide film has a film thickness of 10 $\mu$m or more and a film density of 96% or more; and, in a case where the surface of the yttrium oxide coating film is observed with a microscope, the area ratio of the particulate portions is 0% to 20% in an observation range of 20 $\mu$m $\times$ 20 $\mu$m and the area ratio of the non-particulate portions is 80% to 100% in the observation range.

Patent Document 1 discloses that, in the plasma treatment apparatus part, by including an underlayer consisting of a metal oxide film having a thermal conductivity of 35 W/m·K or less, generation of particles from the film and peeling of the film is stably and effectively suppressed while suppressing production of reaction products on a surface of the film and generation of particles from the reaction products, and it is possible to improve film density of the yttrium oxide film provided on the underlayer, and form the yttrium oxide film in which internal defects, internal strain, or microcracks do not substantially occur.

[Citation List]

[Patent Document]

[Patent Document 1]

PCT International Publication No. WO2013/176168

SUMMARY OF INVENTION

Technical Problem

However, since the underlayer covering the surface of the substrate, disclosed in Patent Document 1, is formed by the thermal spraying method, and the yttrium oxide film on this underlayer is formed by an impact sintering method, the yttrium oxide film still has many defects such as pores, and the yttrium oxide film has a problem of crystal distortion.

An objective of the present invention is to form a plasma-resistant coating film containing highly crystalline $Y_2O_3$ particles, which is dense, has few void defects such as pores and voids in the film, and has high plasma resistance; and a sol gel liquid for forming the film. Another objective of the present invention is to provide a method for forming such a plasma-resistant coating film. Still another objective of the present invention is to provide a substrate including such a plasma-resistant coating film. In the present specification, the plasma resistance of the plasma-resistant coating film refers to not only a phenomenon in which a film surface is physically sputtered and depleted in a case where charged particles are accelerated by an electric field and collide, but also to the resistance to chemical erosion and depletion of the film surface due to active atoms or molecules (radical species) that are inevitably generated in plasma.

Solution to Problem

A first aspect according to the present invention is a plasma-resistant coating film formed on a substrate, including crystalline $Y_2O_3$ particles having an average particle diameter of 0.5 $\mu$m to 5.0 $\mu$m in a $SiO_2$ film, in which a film density of the plasma-resistant coating film is 90% or more, the film density being obtained by performing image analysis of a cross section of the film with an electron scanning microscope and by using the following expression (1), a size of pores in the film is 5 $\mu$m or less in terms of diameter, and a peeling rate of the film from the substrate measured by performing a cross-cut test is 5% or less.

$$\text{Film density } (\%) = [(S_1 - S_2)/S_1] \times 100 \quad (1)$$

However, in the expression (1), S1 is an area of the film and $S_2$ is an area of a pore portion in the film.

A second aspect according to the present invention is an invention based on the first aspect, and is a plasma-resistant coating film in which an atomic concentration ratio (Y/Si) of yttrium (Y) to silicon (Si) in the coating film obtained by performing EDS analysis is 4 to 7.

A third aspect according to the present invention is an invention based on the first or second aspect, and is a plasma-resistant coating film in which the average film thickness of the plasma-resistant coating film is 10 $\mu$m to 300 $\mu$m.

A fourth aspect according to the present invention is an invention based on any one of the first to third aspects, and is a plasma-resistant coating film in which a main peak for a $Y_2O_3$ crystal in X-ray diffraction of the film appears in a range of $2\theta$ = 29 degrees to 29.5 degrees, and a half width of the main peak is 0.14 degrees to 0.25 degrees.

A fifth aspect according to the present invention is an invention based on any one of the first to fourth aspects, and is a plasma-resistant coating film in which the substrate is one of the group consisting of aluminum, alumina, silicon, silicon oxide, and quartz.

A sixth aspect according to the present invention is a sol gel liquid for forming a plasma-resistant coating film, which is obtained by uniformly dispersing crystalline $Y_2O_3$ particles having an average particle diameter of 0.5 $\mu$m to 5.0 $\mu$m in a silica sol gel liquid at a proportion of 0.1 g/mL to 2.5 g/mL.

A seventh aspect according to the present invention is a method for forming a plasma-resistant coating film, including coating and drying the sol gel liquid for forming a plasma-resistant coating film of the sixth aspect onto a substrate, and subjecting the plasma-resistant coating film to a heat treatment at a temperature of 250°C to 400°C under an air atmosphere, in which a procedure from the application of the sol gel liquid to the heat treatment is performed once or repeated multiple times.

A eighth aspect according to the present invention is an invention based on the seventh aspect, and is a method for forming a plasma coating film, in which the substrate is one of the group consisting of aluminum, alumina, silicon, silicon oxide, and quartz.

A ninth aspect according to the present invention is a substrate with a plasma-resistant coating film, including a substrate and the plasma-resistant coating film according to any one of the first to fifth aspects, which is formed on a surface of the substrate.

Advantageous Effects of Invention

In the plasma-resistant coating film of the first aspect according to the present invention, since the crystalline $Y_2O_3$ particles are contained in the SiOz film, the film density is 90% or more, the size of pores in the film is as small as 5 $\mu$m or less in terms of diameter, and adhesion is high, in a case of being irradiated with plasma in a plasma treatment apparatus, the crystalline $Y_2O_3$ particles contained in the $SiO_2$ film are not easily etched, and high plasma resistance comparable to that of bulk $Y_2O_3$ is exhibited.

In the plasma-resistant coating film according to the second aspect of the present invention, since the atomic concentration ratio (Y/Si) of yttrium (Y) to silicon (Si) in the coating film is 4 to 7, there is an advantage that the ratio of the $Y_2O_3$ particles in the $SiO_2$ film is high.

In the plasma-resistant coating film according to the third aspect of the present invention, since the average film thickness of the plasma-resistant coating film is 10 $\mu$m to 300 $\mu$m, there are no cracks in the film, service life of the coating film can be extended, and the coating film can be used in a wide range of applications.

In the plasma-resistant coating film according to the fourth aspect of the present invention, since the crystalline $Y_2O_3$ particles are used, the half width of the $Y_2O_3$ crystal at the main peak is 0.14 degrees to 0.25 degrees, and there is an advantage that the $Y_2O_3$ particles are highly crystalline and have improved etching resistance.

In the plasma-resistant coating film according to the fifth aspect of the present invention, since the substrate is aluminum, alumina, silicon, silicon oxide, or quartz, the $SiO_2$ film has higher adhesion to the substrate.

In the sol gel liquid for forming a plasma-resistant coating film according to the sixth aspect of the present invention, since the crystalline $Y_2O_3$ particles having a predetermined average particle diameter are contained at a predetermined concentration, a dense and high-density crystalline $Y_2O_3$ film can be formed by coating.

In the method for forming a plasma-resistant coating film according to the seventh aspect of the present invention, since the sol gel liquid for forming a plasma-resistant coating film is applied and dried onto the substrate, and then the plasma-resistant coating film is subjected to a heat treatment at a predetermined temperature under an air atmosphere, a plasma-resistant coating film with high adhesion to the substrate can be formed, and the $SiO_2$ film is difficult to be peeled off from the substrate.

In the method for forming a plasma-resistant coating film according to the eighth aspect of the present invention, since the substrate is aluminum, alumina, silicon, silicon oxide, or quartz, the $SiO_2$ film has higher adhesion to the substrate.

In the substrate with a plasma-resistant coating film according to the ninth aspect of the present invention, since the substrate with a plasma-resistant coating film includes the plasma-resistant coating film having an advantage such as high plasma resistance, the substrate with a plasma-resistant coating film is useful as a plasma treatment apparatus part.

BRIEF DESCRIPTION OF DRAWINGS

FIG. 1 is an enlarged schematic cross-sectional view of a plasma-resistant coating film according to the present embodiment, which is formed on a substrate.
FIG. 2 is a flowchart for forming the plasma-resistant coating film according to the present embodiment.

DESCRIPTION OF EMBODIMENTS

Next, embodiments for implementing the present invention will be described with reference to the drawings.

[Method for producing sol gel liquid for forming plasma-resistant coating film]

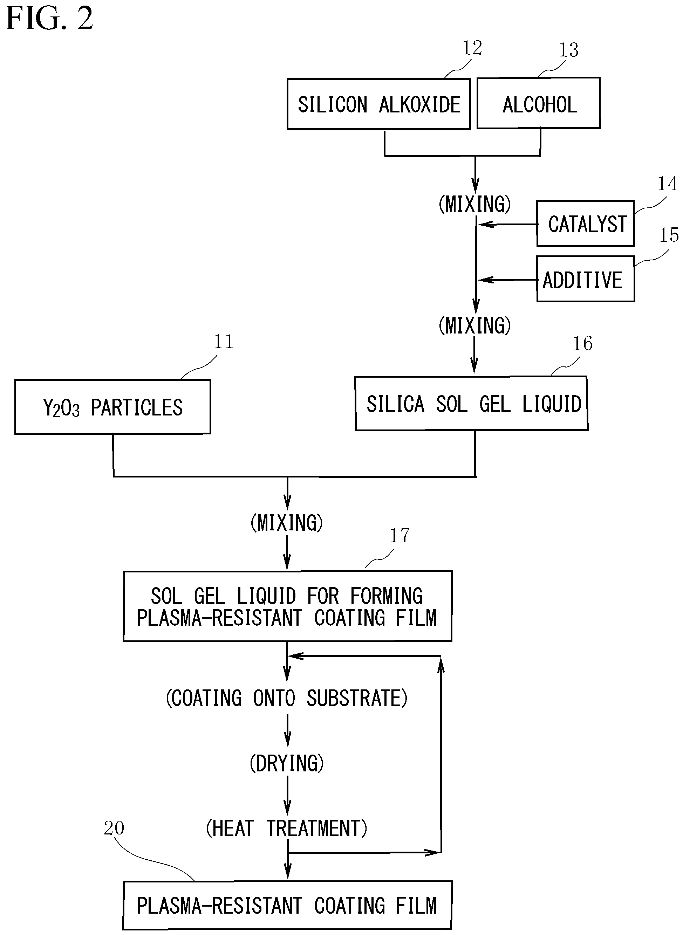

A sol gel liquid for forming a plasma-resistant coating film is generally produced by the following method. As shown in FIG. 2, $Y_2O_3$ particles 11 are prepared. On the other hand, a silica sol gel liquid 16 is prepared by mixing a silicon alkoxide 12 and an alcohol 13, and adding a catalyst 14 and an additive 15 to the mixed solution. By mixing the silica sol gel liquid 16 and the above-described $Y_2O_3$ particles 11, a sol gel liquid 17 for forming a plasma-resistant coating film is produced. Each step will be described in detail below.

[Preparation of $Y_2O_3$ particles]

As the $Y_2O_3$ particles, crystalline $Y_2O_3$ particles are prepared. Commercially available crystalline $Y_2O_3$ particles can be used as the crystalline $Y_2O_3$ particles. Examples thereof include commercially available products manufactured by NIPPON YTTRIUM CO., LTD. and commercially available products manufactured by Shin-Etsu Chemical Co., Ltd. The $Y_2O_3$ particles have an average particle diameter of 0.5 $\mu$m to 5.0 $\mu$m, preferably 1 $\mu$m to 3 $\mu$m. In a case where the average particle diameter is less than 0.5 $\mu$m, the $Y_2O_3$ particles contained in the $SiO_2$ film are likely to be etched when irradiated with plasma. In a case of being more than 5.0 $\mu$m, when the sol gel liquid for forming a plasma-resistant coating film is used for forming a film on a substrate, which will be described later, it is easy to become a crack origin of the formed plasma-resistant coating film. In order to increase arrangement density of the $Y_2O_3$ particles in the plasma-resistant coating film, the $Y_2O_3$ particles may be composed of first particles having an average particle diameter of 0.5 $\mu$m to 2 $\mu$m and second particles having an average particle diameter of 3 $\mu$m to 5 $\mu$m. As a result, by coating, the small-diameter first particles are placed in voids between the large-diameter second particles, so that the $Y_2O_3$ particles can be arranged on the substrate at a higher density, which is preferable. The mass ratio (second particles/first particles) of the second particles to the first particles is preferably 1 to 5. In the present specification, the average particle diameter of the $Y_2O_3$ particles refers to the average value (D50: median diameter) of particle diameters measured by a laser diffraction and scattering method using MT3000 manufactured by Microtrac Retsch GmbH.

[Preparation of silica sol gel liquid]

First, a mixed solution is prepared by mixing silicon alkoxide and an alcohol having a boiling point of lower than 150°C and having 1 to 4 carbon atoms. In this case, an epoxy group-containing silane as an alkylene group-component in order to enhance bonding strength between the $SiO_2$ film formed of the silica sol gel liquid and the substrate, formamide in order to increase a film thickness, or the like may be mixed together as an additive. Specific examples of the silicon alkoxide include tetramethoxysilane (TMOS) or an oligomer thereof, and tetraethoxysilane (TEOS) or an oligomer thereof. For example, for the purpose of obtaining a highly durable plasma-resistant coating film, tetraethoxysilane is preferably used.

Examples of the alcohol having a boiling point of lower than 150°C and having 1 to 4 carbon atoms include alcohols such as methanol, ethanol, isopropanol, and 1-butanol. 1-butanol is particularly preferable. This is because 1-butanol has moderate volatility which is difficult to volatilize at room temperature. The mixed solution is prepared by adding the alcohol having 1 to 4 carbon atoms and water to the silicon alkoxide, and preferably stirring the mixture at a temperature of 10°C to 30°C for 30 minutes or more.

A catalyst is added to and mixed with the mixed solution prepared above. In a case where the silica sol gel liquid is regarded as 100% by mass, it is preferable that the silica sol gel liquid contains, as a proportion, 2% by mass to 50% by mass of the silicon alkoxide, 20% by mass to 98% by mass of the alcohol having 1 to 4 carbon atoms, 0.01% by mass to 5% by mass of the catalyst, and 0.01% by mass to 5% by mass of the additive. Examples of the catalyst include organic acids, inorganic acids, and organic compounds. Examples of the additive include formamide described above, and acetylacetone. In this case, a liquid temperature is preferably maintained at a temperature of 10°C to 30°C, and the mixture is stirred for preferably 1 hour to 24 hours. The silica sol gel liquid is thus prepared.

The above-described catalyst is used to promote hydrolysis reaction. Examples of the organic acid include formic acid and oxalic acid, and examples of the inorganic acid include hydrochloric acid, nitric acid, and phosphoric acid. The catalyst is not limited to those described above. The reason why a proportion of the above-described catalyst is limited to the above-described range is that, in a case of being below the lower limit value, the film is not formed due to poor reactivity and insufficient polymerization, and even in a case of being above the upper limit value, there is no effect on the reactivity, but the residual acid tends to cause corrosion or the like on the substrate on which the film is formed.

The amount $SiO_2$ (hereinafter, referred to as an equivalent $SiO_2$ concentration) in the silica sol gel liquid, which corresponds to $SiO_2$ generated from the silica sol gel liquid, is preferably 1% by mass to 40% by mass, and more preferably 5% by mass to 20% by mass. In a case where the equivalent $SiO_2$ concentration is below the lower limit value, the polymerization is insufficient, bonding property between the $Y_2O_3$ particles, which will be described later, is poor, and the $Y_2O_3$ particles tend to fall off from the $SiO_2$ film. In addition, deterioration of the adhesion of the film and generation of cracks are likely to occur. Furthermore, in a case of being above the upper limit value, the viscosity of the silica sol gel liquid increases, and coating properties of the silica sol gel liquid tend to deteriorate.

[Sol gel liquid for forming plasma-resistant coating film]

The sol gel liquid for forming a plasma-resistant coating film according to the present embodiment is prepared by mixing the $Y_2O_3$ particles with the silica sol gel liquid using a stirrer such as a magnetic stirrer. The mixing is preferably carried out so that the above-described $Y_2O_3$ particles have a concentration proportion of 0.1 g/mL to 2.5 g/mL in the above-described sol gel liquid for forming a plasma-resistant coating film. In a case where the concentration of the $Y_2O_3$ particles is less than 0.1 g/mL, it is difficult to increase a film density of the plasma-resistant coating film to 90% or more, and in a case of being more than 2.5 g/mL, the sol gel liquid for forming a plasma-resistant coating film does not become liquid, and coating on the surface of the substrate tends to be poor. The mixing proportion thereof is more preferably 1.5 g/mL to 2 g/mL.

In the sol gel liquid for forming a plasma-resistant coating film according to the present embodiment, since the crystalline $Y_2O_3$ particles having a predetermined average particle diameter is uniformly dispersed at a predetermined concentration, in a case of being applied onto the surface of the substrate, dried, and further subjected to a heat treatment as will be described later, the crystalline $Y_2O_3$ particles are contained in the $SiO_2$ film on the substrate, and the crystalline $Y_2O_3$ particles are bonded to each other and arranged to form a dense and high-density crystalline $Y_2O_3$ film.

In the sol gel liquid for forming a plasma-resistant coating film according to the present embodiment, in addition to the $Y_2O_3$ particles, $YF_3$ particles may be contained at a concentration proportion of 0.1 g/mL to 1.0 g/mL. In a case of containing the $YF_3$ particles, a film having higher plasma resistance is obtained.

[Method for forming plasma-resistant coating film on surface of substrate]

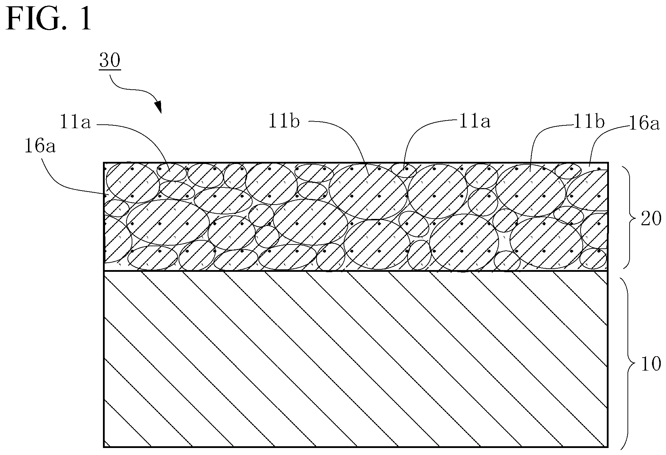

As shown in FIGS. 1 and 2, in a case where the sol gel liquid 17 for forming a plasma-resistant coating film is applied onto the substrate 10, dried at a temperature of 70°C to 100°C under an air atmosphere, and subjected to a heat treatment at 250°C to 400°C, preferably 250°C to 350°C, the silica sol gel component contained in the sol gel liquid 17 for forming a plasma-resistant coating film becomes a $SiO_2$ film (silica sol gel) 16a, and dispersed crystalline $Y_2O_3$ particles 11a and 11b are bonded to each other by the $SiO_2$ film and arranged on the substrate 10. As a result, a plasma-resistant coating film 20 according to the present embodiment is formed on the surface of the substrate 10. That is, a substrate 30 with a plasma-resistant coating film, including the substrate 10 and the plasma-resistant coating film 20 formed on the surface of the substrate 10, is obtained.

In a case where the temperature of the heat treatment is lower than 250°C, adhesion of the formed film to the surface of the substrate is deteriorated. In a case of being higher than 400°C, a substrate which does not have high heat resistance, such as aluminum, is thermally deformed, and it is not possible to form a uniform plasma-resistant coating film. In order to obtain a desired film thickness, the procedure from the application onto the substrate to the heat treatment may be repeated one or more times.

Various materials can be adopted as the substrate depending on the application. In particular, examples of a preferred material of the substrate include aluminum, alumina, silicon, silicon oxide, and quartz, which are usually used as a plasma treatment apparatus part. In addition, examples of the method of coating the sol gel liquid for forming a plasma-resistant coating film include spin coating, screen-printing, bar coating, die coating, doctor blade, brush coating, dipping, and spraying.

As shown in FIG. 1, in the plasma-resistant coating film 20 formed on the surface of the substrate 10, a plurality of crystalline $Y_2O_3$ particles 1 1a and 11b having an average particle diameter of 0.5 $\mu$m to 5.0 $\mu$m are dispersed in the $SiO_2$ film. In a case where the crystalline $Y_2O_3$ particles are composed of small-diameter first particles 11a and large-diameter second particles 11b, the small-diameter first particles 11a are placed in voids between the large-diameter second particles 11b, and the $Y_2O_3$ particles are densely dispersed in the $SiO_2$ film. The $SiO_2$ film is formed on the surface of the substrate 10 with high adhesion. The film thickness of the plasma-resistant coating film according to the present embodiment is preferably 10 $\mu$m to 300 $\mu$m, and more preferably 150 $\mu$m to 250 $\mu$m. In a case where the film thickness is less than 10 $\mu$m, the service life of the plasma-resistant coating film tends to be short. In a case where the film thickness is more than 300 $\mu$m, the cracks are likely to occur in the film.

In addition, in the present embodiment, the plasma-resistant coating film may include pores having a diameter of 5 $\mu$m or less, but does not include pores (voids) having a diameter of more than 5 $\mu$m. This is because, in a case where a large pore of more than 5 $\mu$m exists, a problem arises in that etching is accelerated due to non-uniform voltage application in the vicinity of the pore.

Furthermore, the plasma-resistant coating film according to the present embodiment may include the $YF_3$ particles in addition to the $Y_2O_3$ particles. In a case of containing the $YF_3$ particles, a film having higher plasma resistance is obtained.

In the plasma-resistant coating film according to the present embodiment, a film density of the plasma-resistant coating film is 90% or more, preferably 95% or more, the film density being obtained by performing image analysis of a cross section of the film with an electron scanning microscope (manufactured by Hitachi, Ltd., model name: NB5000) and by using the following expression (1). However, in the expression (1), $S_1$ is an area of the film in a portion of 10 $\mu$m $\times$ 30 $\mu$m, analyzed by the image analysis, and $S_2$ is an area of a pore portion in the film of the portion.

$$\text{Film density } (\%) = [(S_1 - S_2)/S_1] \times 100 \ (1)$$

In addition, the plasma-resistant coating film according to the present embodiment a peeling rate of the film from the substrate measured by performing a cross-cut test is 5% or less, preferably 10% or less. Specifically, in the cross-cut test of the film, the plasma-resistant coating film (film thickness: 20 $\mu$m) formed on a substrate of a mirror surface-processed silicon substrate is cross-cut in 1 mm width in a grid pattern, an adhesive tape (manufactured by NICHIBAN Co., Ltd., product name "Cellotape (registered trademark)") is applied to the cross-cut film in the grid pattern, and a Cellotape (registered trademark) peeling test (hereinafter, simply referred to as a peeling test) is conducted in accordance with a grid pattern tape method of JIS K5600-5-6 (cross-cut method). 100 cross-cut squares are expressed as the denominator, the number of squares remaining on the substrate after the peeling test is expressed as the numerator, and a proportion of completely peeled squares to the 100 squares is the peeling rate (%). That is, the peeling rate is expressed as (number of peeling parts/number of cut parts) $\times$ 100. Here, the number of peeling parts corresponds to the number of squares in which the film is completely peeled off from the substrate by performing the cross-cut test.

EXAMPLES

Next, Examples of the present invention will be described in detail together with Comparative Examples.

<Example 1>

First $Y_2O_3$ particles and second $Y_2O_3$ particles were mixed with each other such that a mass ratio (second particles/first particles) of the second particles to the first particles was 2. On the other hand, hydrochloric acid and acetylacetone were added to a mixed solution of tetraethoxysilane (TEOS) and 1-butanol, and mixed at room temperature of 25°C for 3 hours to obtain a silica sol gel liquid. The equivalent $SiO_2$ concentration (amount $SiO_2$) in the silica sol gel liquid excluding the solvent was 10% by mass. A mixed solution of the silica sol gel liquid, the first $Y_2O_3$ particles, and the second $Y_2O_3$ particles was mixed such that the concentration of $Y_2O_3$ particles was 2 g/mL to prepare a sol gel liquid for forming a plasma-resistant coating film. The sol gel liquid was applied onto a silicon substrate by spin coating, dried at 75°C, and subjected to a heat treatment at 300°C under an air atmosphere to form a plasma-resistant coating film containing the $Y_2O_3$ particles in the $SiO_2$ film.

Table 1 below shows preparation conditions and heat treatment temperatures during film formation for each sol gel liquid for forming a plasma-resistant coating film of Example 1, and Examples 2 to 8 and Comparative Examples 2 and 3 described later.

The average particle diameter of the $Y_2O_3$ particles in the sol gel liquid forming a plasma-resistant coating film was measured by a laser diffraction and scattering method using MT3000 manufactured by Microtrac Retsch GmbH. The average particle diameter was D50: median diameter.

[Table 1]

| | Sol gel liquid for forming plasma-resistant coating film | | | | | | Film formation condition |
| --- | --- | --- | --- | --- | --- | --- | --- |
| | Crystalline $Y_2O_3$ particles | | | Silica sol gel liq uid | | | |
| | Average particle diameter of first particles | Average particle diameter of second particles | Ratio of second particles to first particles (mass ratio) | Equivalent $SiO_2$ concentration (amount $SiO_2$) | Concentration of $Y_2O_3$ particles (g/mL) | Average particle diameter of $Y_2O_3$ particles ($\mu$m) | Heat treatment temperature (°C) |
| | ($\mu$m) | ($\mu$m) | (second particles/first particles) | (% by mass) | | | |
| Example 1 | 1 | 3 | 3 | 10 | 2 | 1.23 | 300 |
| Example 2 | 1 | 3 | 3 | 10 | 2 | 1.18 | 400 |
| Example 3 | 1 | 3 | 1 | 10 | 2 | 1.10 | 300 |
| Example 4 | 1 | 3 | 3 | 10 | 1.5 | 1.22 | 250 |
| Example 5 | - | 3 | - | 10 | 2 | 3.05 | 300 |
| Example 6 | 1 | - | - | 10 | 2 | 1.01 | 300 |
| Example 7 | 0.5 | 5 | 3 | 10 | 2 | 0.51 | 300 |
| Example 8 | - | 5 | - | 10 | 2 | 5.00 | 300 |
| Comparative Example 1 | - | - | - | - | - | - | - |
| Comparative Example 2 | 5 | 10 | 1 | 10 | 2 | 6.10 | 300 |
| Comparative Example 3 | 1 | 3 | 3 | 10 | 2 | 1.22 | 200 |

<Examples 2 to 4>

In Examples 2 to 4, the same first $Y_2O_3$ particles and second $Y_2O_3$ particles as in Example 1 were used, and the mass ratio (second particles/first particles) of the second particles to the first particles was varied or the same as in Example 1, as shown in Table 1. In addition, the equivalent $SiO_2$ concentration in the silica sol gel liquid excluding the solvent and the concentration of the $Y_2O_3$ particles in the sol gel liquid for forming a plasma-resistant coating film was varied or the same as in Example 1, as shown in Table 1. A plasma-resistant coating film was formed on the silicon substrate in the same manner as in Example 1, except that the heat treatment temperature of the obtained sol gel liquid for forming a plasma-resistant coating film was varied or the same as in Example 1.

<Examples 5, 6, and 8>

In Example 5, only a dispersion liquid of second $Y_2O_3$ particles, in which $Y_2O_3$ particles (second particles) having an average particle diameter of 3 $\mu$m were dispersed, was used. In Example 6, only a dispersion liquid of first $Y_2O_3$ particles, in which $Y_2O_3$ particles (first particles) having an average particle diameter of 1 $\mu$m were dispersed, was used. In Example 8, only a dispersion liquid of second $Y_2O_3$ particles, in which $Y_2O_3$ particles (second particles) having an average particle diameter of 5 $\mu$m were dispersed, was used. In Examples 5, 6, and 8, except for the above, the silica sol gel liquid shown in Table 1 was used to adjust the concentration of the $Y_2O_3$ particles. A plasma-resistant coating film was formed on the silicon substrate in the same manner as in Example 1 in a state that the heat treatment temperature of the obtained sol gel liquid for forming a plasma-resistant coating film was the same as in Example 1.

<Example 7>

In Example 7, as shown in Table 1, $Y_2O_3$ particles (first particles) having an average particle diameter of 0.5 $\mu$m and $Y_2O_3$ particles (second particles) having an average particle diameter of 5 $\mu$m were mixed such that the mass ratio of the second particles to the first particles was 3, and a silica sol gel liquid having an equivalent $SiO_2$ concentration excluding the solvent, as shown in Table 1, was further mixed to prepare a sol gel liquid for forming a plasma-resistant coating film having a concentration of the $Y_2O_3$ particles as shown in Table 1. Thereafter, a plasma-resistant coating film was obtained as shown in Table 1.

<Comparative Example 1>

In Comparative Example 1, a plasma-resistant coating film was formed by the thermal spraying method disclosed in Patent Document 1.

<Comparative Example 2>

In Comparative Example 2, as shown in Table 1, $Y_2O_3$ particles (first particles) having an average particle diameter of 5 $\mu$m and $Y_2O_3$ particles (second particles) having an average particle diameter of 10 $\mu$m were mixed such that the mass ratio of the second particles to the first particles was 1, and a silica sol gel liquid having an equivalent $SiO_2$ concentration excluding the solvent, as shown in Table 1, was further mixed to prepare a sol gel liquid for forming a plasma-resistant coating film having a concentration of the $Y_2O_3$ particles as shown in Table 1.

<Comparative Example 3>

In Comparative Example 3, the same sol gel liquid for forming a plasma-resistant coating film as in Example 1 was prepared, but the heat treatment temperature was changed to 200°C. A plasma-resistant coating film was obtained in the same manner as in Example 1 except for the above.

<Comparative test and evaluation>

With regard to the 11 kinds of plasma-resistant coating films obtained in Examples 1 to 8 and Comparative Examples 1 to 3, (a) a film density, (b) a peeling rate from the substrate, (c) an atomic concentration ratio (Y/Si) of yttrium (Y) to silicon (Si) on the surface of the coating film, (d) a film thickness, (e) a half width of a main peak for a $Y_2O_3$ crystal in X-ray diffraction of the film, appearing in a range of $2\theta = 29$ degrees to 29.5 degrees, (f) the presence or absence of pores having a diameter of more than 5 $\mu$m in the film, and (g) the average particle diameter of the $Y_2O_3$ particles in the film were measured.

The (a) film density and the (b) peeling rate from the substrate were measured by the methods described above.

The (c) atomic concentration ratio was measured with energy dispersive X-ray spectroscopy (EDS, manufactured by Bruker, model name: QUANTAX). The (d) film thickness was measured by SEM cross section method. In addition, the (e) half width was measured with an X-ray diffraction (XRD) device (manufactured by Rigaku Corporation, model name: RINT Ultima III).

In addition, for the (f) presence or absence of pores, a cross section of the film was imaged at 10 random locations with an electron scanning microscope (manufactured by Hitachi, Ltd., model name: NB5000) at a magnification of 1000 times, and in a case where there was no pore larger than 5 $\mu$m in terms of diameter corresponding to the area circle (diameter of the circle having the same area), it was evaluated as "absence", and in a case where there was at least one pore larger than 5 $\mu$m, it was evaluated as "presence". Furthermore, the (g) average particle diameter of the $Y_2O_3$ particles was measured with electron beam backscatter diffraction (EBSD, manufactured by TSL Solutions Co., Ltd., Hikari). As for the measurement conditions, the average particle diameter was calculated by image analysis of the particle diameter of the film area portion of 10 $\mu$m $\times$ 30 $\mu$m with a visual field image magnified by 10000 times. An area circle equivalent diameter was used for the average particle diameter. These results are shown in Table 2 below.

[Table 2]

| | Evaluation of plasma-resistant coating film | | | | | | |
|---|---|---|---|---|---|---|---|
| | Film density (%) | Peeling rate (%) | (Y/Si) (atomic concentration ratio) | Film thickness ($\mu$m) | Half width (degree) | Presence or absence of pores larger than 5 $\mu$m | Average particle diameter of $Y_2O_3$ particles ($\mu$m) |
| Example 1 | 98.7 | 0 | 6 | 80 | 0.19 | Absence | 1.25 |
| Example 2 | 99 | 0 | 5 | 80 | 0.19 | Absence | 1.20 |
| Example 3 | 99 | 1 | 5 | 80 | 0.20 | Absence | 1.10 |
| Example 4 | 96 | 4 | 6 | 80 | 0.18 | Absence | 1.20 |
| Example 5 | 94 | 0 | 6 | 80 | 0.19 | Absence | 3.10 |
| Example 6 | 94 | 2 | 4.5 | 80 | 0.17 | Absence | 1.00 |
| Example 7 | 96 | 3 | 7 | 60 | 0.19 | Absence | 0.50 |
| Example 8 | 90 | 5 | 4 | 60 | 0.19 | Absence | 5.00 |
| Comparative Example 1 | 96 | 1 | 0 | 200 | 0.20 | Presence | - |
| Comparative Example 2 | 60 | 1 | 10 | 150 | 0.18 | Absence | 6.00 |
| Comparative Example 3 | 96 | 35 | 6 | 100 | 0.19 | Absence | 1.20 |

As is clear from Table 2, since the plasma-resistant coating film of Comparative Example 1 was formed by the thermal spraying method, the film density was as high as 96%, but there were pores larger than 5 $\mu$m and the result was "presence". Therefore, it was expected that the film would be easily etched when irradiated with plasma in a plasma treatment apparatus, and that the plasma resistance would not be high.

Since the plasma-resistant coating film of Comparative Example 2 contained the $Y_2O_3$ particles (second particles) having an average particle diameter of 10 $\mu$m in addition to the $Y_2O_3$ particles (first particles) having an average particle diameter of 5 $\mu$m, the film density was as low as 60%. In addition, the average particle diameter of the $Y_2O_3$ particles in the film was 6.00 $\mu$m, and cracks were observed in the film.

In the plasma-resistant coating film of Comparative Example 3, since the heat treatment temperature was as low as 200°C, the film density was as high as 96%, but the peeling rate of the film was as high as 35% and the adhesion of the film to the substrate was poor.

On the other hand, since the plasma-resistant coating films of Examples 1 to 8 contained a plurality of crystalline $Y_2O_3$ particles having an average particle diameter of 0.5 $\mu$m to 5.0 $\mu$m in the $SiO_2$ film, the scope of the invention of the first aspect, that the film density was 90% or more, the size of pores in the film was 5 $\mu$m or less in diameter, and the peeling rate of the film from the substrate was 5% or less, was satisfied.

In particular, in Examples 1, 4, and 7 in which the crystalline $Y_2O_3$ particles were composed of the first particles having an average particle diameter of 0.5 μm to 1 μm and the second particles having an average particle diameter of 3 μm to 5 μm, the film density was as high as 96% or more, and high adhesion was exhibited.

INDUSTRIAL APPLICABILITY

The plasma-resistant coating film according to the present invention is used as a protective film for a plasma treatment apparatus part that is irradiated with plasma in a plasma treatment apparatus.

[Reference Signs List]

10: Substrate
11a: $Y_2O_3$ particles (small-diameter first particles)
11b: $Y_2O_3$ particles (large-diameter second particles)
16a: Silica sol gel
20: Plasma-resistant coating film
30: Substrate with a plasma-resistant coating film

**Claims**

1. A plasma-resistant coating film formed on a substrate, comprising:

   crystalline $Y_2O_3$ particles having an average particle diameter of 0.5 μm to 5.0 μm in a $SiO_2$ film,
   wherein a film density of the plasma-resistant coating film is 90% or more, the film density being obtained by performing image analysis of a cross section of the film with an electron scanning microscope and by using the following expression (1),
   a size of pores in the film is 5 μm or less in terms of diameter, and
   a peeling rate of the film from the substrate measured by performing a cross-cut test is 5% or less,

   $$\text{Film density } (\%) = [(S_1 - S_2)/S_1] \times 100 \ (1)$$

   provided that, in the expression (1), $S_1$ is an area of the film and $S_2$ is an area of a pore portion in the film.

2. The plasma-resistant coating film according to Claim 1,
   wherein an atomic concentration ratio (Y/Si) of yttrium (Y) to silicon (Si) in the resistant coating film obtained by performing EDS analysis is 4 to 7.

3. The plasma-resistant coating film according to Claim 1 or 2,
   wherein an average film thickness of the plasma-resistant coating film is 10 μm to 300 μm.

4. The plasma-resistant coating film according to any one of Claims 1 to 3,

   wherein a main peak for a $Y_2O_3$ crystal in X-ray diffraction of the film appears in a range of 2θ = 29 degrees to 29.5 degrees, and
   a half width of the main peak is 0.14 degrees to 0.25 degrees.

5. The plasma-resistant coating film according to any one of Claims 1 to 4,
   wherein the substrate is one of the group consisting of aluminum, alumina, silicon, and silicon oxide.

6. A sol gel liquid for forming a plasma-resistant coating film, which is obtained by uniformly dispersing a plurality of crystalline $Y_2O_3$ particles having an average particle diameter of 0.5 μm to 5.0 μm in a silica sol gel liquid at a proportion of 0.1 g/mL to 2.5 g/mL.

7. A method for forming a plasma-resistant coating film, comprising:

coating and drying the sol gel liquid for forming a plasma-resistant coating film according to Claim 6 onto a substrate; and

subjecting the plasma-resistant coating film to a heat treatment at a temperature of 250°C to 400°C under an air atmosphere,

wherein a procedure from the application of the sol gel liquid to the heat treatment is performed once or repeated multiple times.

8.    The method for forming a plasma-resistant coating film according to Claim 7,
      wherein the substrate is one of the group consisting of aluminum, alumina, silicon, and silicon oxide.

9.    A substrate with a plasma-resistant coating film, comprising:

      a substrate; and
      the plasma-resistant coating film according to any one of Claims 1 to 5, which is formed on a surface of the substrate.

FIG. 1

FIG. 2

## INTERNATIONAL SEARCH REPORT

| International application No. |
|---|
| **PCT/JP2021/033028** |

**A.    CLASSIFICATION OF SUBJECT MATTER**

*H05H 1/24*(2006.01)i; *C04B 41/87*(2006.01)i; *H01L 21/3065*(2006.01)i; *C23C 18/12*(2006.01)i
FI:    H05H1/24; C23C18/12; C04B41/87 B; H01L21/302 101G

According to International Patent Classification (IPC) or to both national classification and IPC

**B.    FIELDS SEARCHED**

Minimum documentation searched (classification system followed by classification symbols)

H05H1/00-1/54; C04B41/87; H01L21/3065; C23C18/12

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 2007-321183 A (NIHON CERATEC CO., LTD.) 13 December 2007 (2007-12-13) entire text, all drawings | 1-9 |
| A | JP 2018-78309 A (APPLIED MATERIALS INC.) 17 May 2018 (2018-05-17) entire text, all drawings | 1-9 |
| A | JP 2008-91489 A (TOKYO ELECTRON LIMITED) 17 April 2008 (2008-04-17) entire text, all drawings | 1-9 |
| A | JP 2004-260159 A (TOKYO ELECTRON LIMITED) 16 September 2004 (2004-09-16) entire text, all drawings | 1-9 |
| A | JP 2004-190136 A (TOKYO ELECTRON LIMITED) 08 July 2004 (2004-07-08) entire text, all drawings | 1-9 |

☐ Further documents are listed in the continuation of Box C.          ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 November 2021** | **22 November 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2021/033028**

| Patent document cited in search report | | | Publication date (day/month/year) | Patent family member(s) | | | Publication date (day/month/year) |
|---|---|---|---|---|---|---|---|
| JP | 2007-321183 | A | 13 December 2007 | (Family: none) | | | |
| JP | 2018-78309 | A | 17 May 2018 | US | 2015/0024155 | A1 | |
| | | | | entire text, all drawings | | | |
| | | | | US | 2017/0301522 | A1 | |
| | | | | US | 2018/0096825 | A1 | |
| | | | | WO | 2015/009745 | A1 | |
| | | | | TW | 201519351 | A | |
| | | | | CN | 105378900 | A | |
| | | | | KR | 10-2016-0034298 | A | |
| | | | | KR | 10-2017-0143022 | A | |
| | | | | CN | 107978507 | A | |
| | | | | TW | 201830554 | A | |
| | | | | CN | 109308988 | A | |
| | | | | TW | 201937632 | A | |
| JP | 2008-91489 | A | 17 April 2008 | CN | 101155463 | A | |
| | | | | entire text, all drawings | | | |
| | | | | KR | 10-2008-0030511 | A | |
| | | | | TW | 200820839 | A | |
| JP | 2004-260159 | A | 16 September 2004 | US | 2005/0103275 | A1 | |
| | | | | entire text, all drawings | | | |
| | | | | US | 2009/0104781 | A1 | |
| | | | | KR | 10-0540051 | B1 | |
| | | | | CN | 1521805 | A | |
| | | | | TW | 200501253 | A | |
| JP | 2004-190136 | A | 08 July 2004 | US | 2005/0103275 | A1 | |
| | | | | entire text, all drawings | | | |
| | | | | US | 2009/0104781 | A1 | |
| | | | | US | 2004/0216667 | A1 | |
| | | | | US | 2010/0307687 | A1 | |
| | | | | US | 2013/0255881 | A1 | |
| | | | | KR | 10-0540051 | B1 | |
| | | | | CN | 1521805 | A | |
| | | | | TW | 200501253 | A | |
| | | | | KR | 10-2004-0048343 | A | |
| | | | | CN | 1516535 | A | |
| | | | | TW | 200423195 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020150914 A
- JP 2021142939 A

- WO 2013176168 A